# EUROPÄISCHE PATENTSCHRIFT

(11) **EP 1 710 849 B1**
(45) Veröffentlichungstag und Bekanntmachung des Hinweises auf die Patenterteilung: **26.12.2012**
(21) Anmeldenummer: 06006613.1
(22) Anmeldetag: 29.03.2006
(51) Int. Cl.: H01L 41/107, H01L 41/047

(54) **Piezoelektrischer Transformator**
Piezoelectric transformer
Transformateur piézo-électrique

(30) Priorität: 05.04.2005 DE 102005015600
(43) Veröffentlichungstag der Anmeldung: 11.10.2006
(73) Patentinhaber: EPCOS AG, 81669 München (DE)
(72) Erfinder: Kartashev, Igor, 8530 Deutschlandsberg (AT); Glazunov, Alexander, 8530 Deutschlandsberg (AT); Florian, Heinz, 8524 Bad Gams (AT)
(74) Vertreter: Epping - Hermann - Fischer

(56) Entgegenhaltungen:
- EP-B- 0 914 681
- EP-B- 1 025 597
- DE-A1- 3 231 117
- JP-A- 4 338 685
- JP-A- 2000 183 417
- JP-A- 2002 324 923
- US-B1- 6 333 589

## Beschreibung

Die Erfindung betrifft einen piezoelektrischen Transformator, der beispielsweise dazu geeignet ist, eine hohe Spannung in eine niedrige Spannung zu transformieren.

Aus der Druckschrift US 2,830,274 ist ein Piezotransformator bekannt, der einen röhrenförmigen piezoelektrischen Körper aufweist.

Die Druckschriften EP 0 914 681 B und EP 1 025 597 B beschreiben jeweils Piezotransformatoren mit einer ersten Zone, die in Dickenrichtung polarisiert ist, und einer zweiten Zone, die in Längsrichtung polarisiert ist. Zur Kontaktierung von Innenelektroden bzw. zur Verbindung der Innenelektroden untereinander sind Verbindungsleitungen im Inneren des Grundkörpers vorgesehen.

In der Druckschrift JP 2002-324923 A ist ein Piezotransformator beschrieben, der in Längsrichtung polarisiert ist und bei dem auf eine piezokeramische Schicht kammartig ineinandergreifende Innenelektroden aufgebracht sind, wobei die Innenelektroden einer Polarität mittels einer Verbindungsleitung an eine gemeinsame Außenelektrode angeschlossen und mehrere derartige piezokeramische Schichten übereinander gestapelt sind.

Die Druckschrift JP 04-338685 A beschreibt einen zylindrischen, scheibenförmigen piezoelektrischen Transformator, bei dem Innenelektroden entlang der Zylinderachse angeordnet sind und der zwei durch Innenelektroden gebildete Bereiche aufweist, von denen der eine den anderen ringförmig umschließt. Zur elektrischen Kontaktierung der Innenelektroden sind im Inneren des Transformators Verbindungsleitungen sowie auf den Stirnseiten des Transformators äußere Elektroden vorgesehen.

Die Druckschrift US 6,333,589 B1 beschreibt einen zylindrischen, scheibenförmigen piezoelektrischen Transformator, bei dem Innenelektroden entlang der Zylinderachse angeordnet sind und der einen Grundkörper mit piezoelektrischen Schichten und Innenelektroden auf weist, die entlang der Zylinderachse übereinander angeordnet sind und einen Eingangsteil sowie einen Ausgangsteilbilden. Die Kontaktierung der Innenelektroden erfolgt durch Außenelektroden, die auf der Mantelfläche des Grundkörpers angeordnet sind.

Es ist Aufgabe der Erfindung, einen piezoelektrischen Transformator anzugeben, der gute Isolationseigenschaften aufweist.

In einer erfindungsgemäßen Ausfuhrungsform des Transformators ist es vorgesehen, dass Innenelektroden mit einer Verbindungsleitung elektrisch kontaktiert sind. Die Verbindungsleitung verbindet dabei mehrere Innenelektroden elektrisch leitend miteinander. Wenigstens eine Verbindungsleitung ist im Inneren eines keramischen Grundkörpers angeordnet,

welcher ein piezoelektrisches Material enthält. Als piezoelektrisches Material kommt insbesondere eine PZT-Keramik (PZT = Blei-Zirkonat-Titanat) in Betracht. Zumindest ein Teil des Grundkörpers, vorzugsweise ein umlaufender Bereich der Grundkörperoberfläche, kann mit einer Abdeckung bedeckt sein.

Der Transformator nutzt sowohl den direkten als auch den inversen piezoelektrischen Effekt.

Es wird unter dem inversen piezoelektrischen Effekt verstanden, dass die piezoelektrische Keramik, die gegebenenfalls zum Einsatz des Bauelementes noch polarisiert werden muss, bei Anlegen eines elektrischen Feldes parallel oder antiparallel oder auch in einem Winkel zur Polarisierungsrichtung eine Verformung erfährt.

Unter dem direkten piezoelektrischen Effekt wird verstanden, dass in dem Grundkörper bei Auftreten von Verformungen eine Spannung abfällt.

Der piezoelektrische Transformator ist in zwei vorzugsweise mechanisch aneinander gekoppelte und galvanisch voneinander getrennte Teile - Eingangsteil und Ausgangsteil - unterteilt. Die galvanische Trennung der beiden Teile ist durch eine dazwischen angeordnete isolierende Trennschicht, vorzugsweise eine im Grundkörper dafür vorgesehene piezoelektrische Schicht erreichbar. Die Durchschlagsspannung des Transformators hängt auch von der Dicke und den elektrischen Eigenschaften dieser isolierenden Trennschicht ab.

Der Eingangsteil und der Ausgangsteil sind entlang einer Längsachse des Transformators nebeneinander angeordnet und z. B. durch eine der im Grundkörper vorgesehenen piezoelektrischen Schichten mechanisch fest miteinander verbunden. Ein elektrisches Eingangssignal wird im Eingangsteil des piezoelektrischen Transformators in mechanische Schwingungen des Grundkörpers des Transformators umgewandelt. Aufgrund der mechanischen Kopplung des Eingangsteils und des Ausgangsteils sind beide Teile von der mechanischen Schwingung betroffen. Die Umwandlung der elektrischen Energie in die mechanische Energie erfolgt aufgrund des inversen piezoelektrischen Effekts. Im Ausgangsteil werden die mechanischen Schwingungen aufgrund des direkten piezoelektrischen Effekts zurück in ein elektrisches Signal verwandelt.

Im Grundkörper können vorteilhafterweise dem Eingangsteil zugeordnete Eingangselektroden und dem Ausgangsteil zugeordnete Ausgangselektroden vorgesehen sein. Mit Hilfe der Eingangselektroden kann bei Anlegen einer Spannung an den Eingangselektroden eine mechanische Verformung des Grundkörpers hervorgerufen werden. Mit Hilfe der Ausgangselektroden kann eine bei Verformung des Körpers auftretende elektrische Spannung abgegriffen werden.

Beim Anlegen einer Wechselspannung an den Eingangselektroden kann eine periodisch wiederkehrende Deformation des Körpers erzeugt werden. Diese periodisch wiederkehrende Deformation des Körpers kann wiederum in den Ausgangselektroden eine sich periodisch ändernde Spannung hervorrufen. Durch geeignete Anordnung der Elektroden kann erreicht werden, dass die Ausgangsspannung von der Eingangsspannung verschieden ist. In diesem Fall erhält man einen Transformator mit einem dem Verhältnis der Spannungen entsprechenden Übersetzungsverhältnis.

Vorzugsweise sind die Eingangselektroden und die Ausgangselektroden, fortan auch als Elektroden bezeichnet, mit Anschlusselementen versehen, um die Elektroden mit einer Eingangsspannungsquelle oder mit einem Abgriff für die Ausgangsspannung kontaktieren zu können.

Die Oberfläche des Grundkörpers ist gemäß wenigstens einem Ausführungsbeispiel wenigstens teilweise - vorzugsweise zumindest auf einem zwischen dem Eingangsteil und dem Ausgangsteil angeordneten Trennbereich (= Trennschicht) - mit einer elektrisch isolierenden Abdeckung bedeckt, die beispielweise rohrförmig ausgebildet sein kann. Die isolierende Abdeckung umhüllt vorzugsweise den Umfang bzw. einen umlaufenden Bereich des Grundkörpers und liegt in einer besonders bevorzugten Ausführungsform am Grundkörper formschlüssig an.

Die Abdeckung, die den Grundkörper des Transformators bedeckt kann den Grundkörper auf all seinen Oberflächen mit Ausnahmen des Außenelektroden bedecken.

Darüber hinaus kann als Material für die Abdeckung ein elektrisch isolierendes Material gewählt werden, um die Gefahr eines elektrischen Überschlags zwischen verschieden gepolten äußeren Elektroden zu reduzieren.

Insbesondere kann als isolierendes Material ein anorganisches Material wie beispielsweise ein glasartiges Material verwendet werden. Das glasartige Material kann z. B. eine chemische Zusammensetzung von 20,5% Gewichtsanteil B₂O₃, 6,8% Gewichtsanteil PbO, 0,3% Gewichtsanteil Sb₂O₃, 10,4% Gewichtsanteil SiO₂ und 62,0% Gewichtsanteil ZnO enthalten.

Materialien mit anderen Zusammensetzungen sind ebenfalls möglich, soweit sie isolierend sind.

Gemäß wenigstens einer Ausführungsform des Transformators ist es vorgesehen, dass das Isoliermaterial ein organisches Material ist. Beispielsweise kommt ein Lack oder ein Verbundmaterial in Betracht

Gemäß einer weiteren Ausführungsform des Transformators enthält die isolierende Abdeckung ein Schrumpfmaterial und kann z. B. einen Schrumpfschlauch umfassen.

Ferner kann jedes Material, welches elektrisch isolierend wirkt und für die Passivierung von elektronischen Komponenten geeignet ist, verwendet werden.

Erfindungsgemäß ist es vorgesehen, dass im inneren des Grundkörpers des Transformators eine Verbindungsleitung verläuft, die mehrere Innenelektroden, vorzugsweise Innenelektroden, die mit dem gleichen elektrischen Potential beaufschlagt werden sollen, miteinander elektrisch leitend verbindet. Einer solchen Ausführungsform des Transformators liegt die Idee zugrunde, die Verbindung der Innenelektroden untereinander und die Positionierung des Außenelektroden des Transformators geometrisch voneinander zu entkoppeln. Dadurch entsteht ein großer Gestaltungsspielraum für die Anordnung und insbesondere auch für die flächenmäßige Ausdehnung der Außenelektroden des Transformators. Der Eingangsteil und der Ausgangsteil eines Transformators weisen jeweils kammartig ineinander greifende Innenelektroden auf, mit deren Hilfe zueinander parallel geschaltete Kondensatoren realisiert werden können. Somit kann ein Großteil des Volumens des Eingangsteils bzw. des Ausgangsteils mit einer Kopplung in dem Volumen des Körpers und dem elektrischen Abgriff des Transformators erzielt werden. Um eine Parallelschaltung der mittels der Innenelektroden gebildeten Kondensatoren zu erreichen, müssen Innenelektroden elektrisch leitend miteinander verbunden werden. Dies kann durch wenigstens eine Kontaktleitung realisiert werden, die mit mehreren Innenelektroden kontaktiert ist und diese somit elektrisch leitend verbindet.

Der piezoelektrische Transformator weist einen keramischen Grundkörper auf. Damit ist ein Körper gemeint, der zur Hauptsache, dass heißt zu einem großen Anteil aus einem keramischen Material besteht. Vorzugsweise wird ein piezoelektrisches Material, beispielsweise eine PZT-Keramik verwendet. Zur Bildung eines piezoelektrischen Bauelementes werden mehrere keramische Grünfolien übereinander gestapelt, miteinander verpresst und anschließend gesintert. Zwischen den keramischen Grünfolien werden Innenelektroden und weitere Elemente, die für den elektrischen Betrieb des Transformators erforderlich sind, angeordnet. Innenelektroden können beispielsweise durch Siebdrucken einer Paste gebildet werden. Im Inneren des Grundkörpers, dass heißt im Inneren des keramischen Körpers verlaufende Verbindungsleitungen können beispielsweise realisiert werden, indem in die einzelnen keramischen Grünfolien Löcher gestanzt werden, welche anschließend mit einer Füllung gefüllt werden.

Die Füllung hat vorzugsweise elektrisch leitende Eigenschaften. Besonders bevorzugt kann diese Füllung eine elektrisch leitende, metallhaltige Paste sein. Vorteilhafterweise kann die als Füllung verwendete Paste auch zum Siebdrucken der Innenelektroden verwendet werden.

Alternativ können die Löcher nach dem Verpressen der Grünfolien in den u.a. aus den Grünfolien gebildeten Grundkörper eingebracht werden. Dies kann beispielsweise durch Bohren oder Fräsen geschehen. Diese Löcher können auf verschiedene Weise elektrisch leitend gemacht werden. Eine erste Möglichkeit kann darin bestehen, die Löcher mit einer elektrisch leitenden, metallhaltigen Paste auszufüllen.

Eine zweite Möglichkeit kann darin bestehen, die Oberfläche der Löcher mit einer elektrisch leitenden, metallhaltigen Paste zu bedecken. Vorteilhafterweise kann für die Herstellung der leitenden Verbindung in den Löchern und der Innenelektroden die gleiche Paste verwendet werden.

Eine dritte Möglichkeit, in den Löchern eine elektrisch leitende Verbindungsleitung zu realisieren, kann in der Verwendung eines metallischen Kontaktes bestehen, wie z.B. eines Drahtes, Litzenkabels, metallischen Stiftes, Rohres, einer Feder oder Bürste.

Eine vierte Möglichkeit kann in der Kombination einer Paste mit einem metallischen Kontakt bestehen. Dies kann sich vor allem dann als vorteilhaft erweisen, wenn der metallische Kontakt erst nach dem Sintern des Grundkörpers in die Löcher eingeführt wird. Die Paste kann dann zu einer verbesserten elektrischen Verbindung zwischen dem metallischen Kontakt und den Innenelektroden führen. Wird der metallische Kontakt hingegen mitgesintert, kann durch die während des Sinterns zwischen dem metallischen Kontakt und den Innenelektroden verursachte thermische Verbindung eine ausreichende elektrische Verbindung gewährleistet werden.

Erfindungsgemäß ist eine Außenelektrode auf einer Stirnseite des Grundkörpers angeordnet. Gemäß wenigstens einer Ausführungsform des Transformators ist es vorgesehen, dass Außenelektroden zur Kontaktierung der Innenelektroden an gegenüberliegenden Stirnseiten des Grundkörpers angeordnet sind. Dadurch kann ein maximaler Abstand zwischen den Außenelektroden erzielt werden. Ein großer Abstand der Außenelektrode ist vorteilhaft um Spannungsüberschläge bzw. Spannungsdurchbrüche zwischen der Primärseite und der Sekundärseite des Transformators zu verhindern. Insbesondere Kriechströme entlang der Oberfläche des Grundkörpers des Transformators können so wirksam reduziert werden.

Besonders vorteilhaft ist dabei die Kombination von maximal voneinander beabstandeten Außenelektroden, wobei sich der maximale Abstand zwischen den Außenelektroden auf den Abstand zwischen einer Außenelektrode der Primärseite und einer Außenelektrode der Sekundärseite des Transformators bezieht. Zwischen diesen Außenelektroden ist das Problem der Spannungsüberschläge besonders kritisch. Die maximal voneinander beabstandeten Außenelektroden können in einer besonders bevorzugten Ausführungsform des Transformators kombiniert werden mit im Inneren des Grundkörpers verlaufenden Verbindungsleitungen. Dabei ist es besonders vorteilhaft, wenn eine Verbindungsleitung eine Außenelektrode mit den dieser Außenelektrode zugeordneten Innenelektroden elektrisch leitend verbindet.

Besonders vorteilhaft ist es, wenn abgesehen von den Stirnseiten des Grundkörpers keine weiteren Metallisierungen auf der Oberfläche des Grundkörpers insbesondere auf den Seitenflächen des Grundkörpers vorhanden sind. Die Seitenflächen des Grundkörpers sind besonders bevorzugt frei von Metallisierungen bzw. metallisierungsfrei. Der Grundkörper kann dabei die Form eines Quaders haben mit einer Längsrichtung, in der der Quader seine größte Ausdehnung hat. Diese Längsrichtung ist auch von Bedeutung für die Polarisierung der keramischen Schichten des Grundkörpers.

Gemäß wenigstens einer Ausführungsform des Transformators ist es vorgesehen, dass eine Verbindungsleitung nur einige der zu einer Außenelektrode gehörenden Innenelektroden elektrisch leitend miteinander verbindet. Nicht mit der Verbindungsleitung an die Außenelektrode angeschlossene Innenelektroden können nämlich auch durch eine entsprechend an den Seitenfläche des Grundkörpers angeordnete Außenelektrode direkt durch diese miteinander verbunden werden. Es ist also auch möglich, eine gemischte Kontaktierung für die Innenelektroden zu wählen, wobei die Innenelektroden teilweise durch eine Verbindungsleitung im Inneren des Grundkörpers und teilweise durch eine an einer Seitenfläche des Grundkörpers liegende Außenelektrode miteinander verbunden werden.

Gemäß wenigstens einer Ausführungsform des Transformators ist es vorgesehen, dass ein Grundkörper mit einem keramischen Vielschichtaufbau bereitgestellt ist. Ein Eingangsteil und ein Ausgangsteil des Transformators sind durch eine Trennschicht voneinander getrennt. Die Trennschicht verbindet den Eingangsteil und den Ausgangsteil mechanisch miteinander. Darüber hinaus hat eine Trennschicht vorzugsweise noch die Funktion einer galvanischen Isolierung. Die Außenelektrode der Eingangsseite des Transformators hat von einer Außenelektrode der Ausgangssseite des Transformators einen Abstand, der größer ist als die Dicke der Trennschicht. Dadurch kann die Spannungsfestigkeit des Transformators verbessert werden.

In einer besonders bevorzugten Ausführungsform des Transformators ist es vorgesehen, dass weit von der Trennschicht entfernte Innenelektroden durch eine Außenelektrode miteinander elektrisch leitend verbunden werden. Nahe an der Trennschicht liegende Innenelektroden werden auf andere Art und Weise untereinander und auch mit der Außenelektrode verbunden. Beispielsweise kann die elektrisch leitende Verbindung aber auch durch eine innenliegende Verbindungsleitung realisiert sein.

Gemäß einer anderen Ausführungsform eines piezoelektrischen Transformators ist es vorgesehen, dass eine Verbindungsleitung, die zwei Innenelektroden bzw. zwei zu einem Kondensator beitragende Elektrodenschichten elektrisch leitend miteinander verbindet, allseitig von einem Keramikmaterial umschlossen ist. Eine Verbindungsleitung kann in ein Keramikmaterial eingebettet sein. Dabei ist diese an all denjenigen Oberflächen der Verbindungsleitung, die nicht direkt zur Kontaktierung mit Innenelektroden bzw. mit einer Außenelektrode benötigt werden, von einem Keramikmaterial umschlossen. Dadurch kann die Gefahr, dass von der Verbindungsleitung Kriechströme bzw. unerwünschte Entladungsströme zu einem anderen elektrischen Pol des Transformators hinfließen, reduziert werden.

Besonders vorteilhaft ist es, wenn die Verbindungsleitung allseitig von ein und demselben Keramikmaterial umschlossen ist.

Gemäß wenigstens einer Ausführungsform eines Transformators ist es vorgesehen, dass ein Grundkörper in einem Vielschichtaufbau mit einer oder mehreren Außenelektroden versehen ist. Die beim Betrieb des Transformators entstehende mechanische Schwingung hat in bestimmten Bereichen des Transformators Schwingungsknoten und in anderen Bereichen des Transformators Schwingungsbäuche.

Die Anordnung eines Außenkontakts im Bereich eines Schwingungsknotens des Grundkörpers hat den Vorteil, dass die Schwingung des Grundkörpers möglichst wenig beeinflusst wird durch die elektrische Kontaktierung. Dadurch kann die Betriebssicherheit und der Energieverlust des Transformators optimiert werden. Darüber hinaus hat die Kontaktierung des Transformators auch eine längere Lebensdauer, da die elektrische Kontaktierung mechanisch weniger belastet wird.

Im folgenden werden Transformatoren anhand von Ausführungsbeispielen und den dazugehörigen Figuren näher erläutert:
Figur 1 zeigt einen schematischen Längsschnitt eines erfindungsgemäßen piezoelektrischen Transformators.
Figur 2 zeigt einen schematischen Längsschnitt eines nicht unter den Schutzbereich der Anspruchs 1 fallenden Transformators.
Figuren 3A und 4A zeigen einen schematischen Querschnitt eines Transformators entsprechend Figur 1.
Figuren 3B und 4B zeigen einen schematischen Querschnitt eines Transformators gemäß Figur 2.
Elemente, die einander gleichen oder die gleiche Funktion haben, sind dabei mit den gleichen Bezugszeichen versehen.

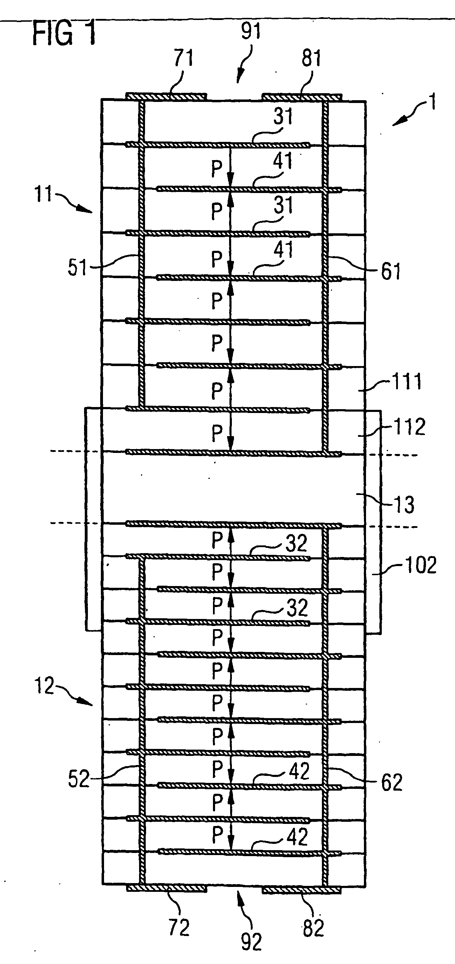

Figur 1 zeigt ausschnittsweise einen piezoelektrischen Transformator mit einem Grundkörper 1, der aus einer piezoelektrischen Keramik, beispielsweise einer PZT-Keramik hergestellt ist. Er weist einen Eingangsteil 11 und einen Ausgangsteil 12 auf. Jeder dieser Teile enthält eine Vielzahl von Innenelektroden. Der Eingangsteil enthält eine Vielzahl von Innenelektroden bzw. Eingangselektroden 31, 41. Diese umfassen Innenelektroden 31 der ersten Sorte, die alle mit einem gemeinsamen äußeren Kontakt - erster Außenelektrode 71 - kontaktiert sind. Die Innenelektroden 41 der zweiten Sorte sind mit einem anderen gemeinsamen äußeren Kontakt - zweiter Außenelektrode 81 - kontaktiert. Innenelektroden der ersten Sorte wechseln sich dabei in der Schichtenfolge mit Innenelektroden der zweiten Sorte ab. Entsprechendes gilt für die an als Außenelektroden ausgebildeten Ausgangselektroden 72, 82 angeschlossene Innenelektroden 32, 42 im Ausgangsteil des Transformators. Die Innenelektroden einer Sorte sind alle mit der gleichen Elektrode und daher mit dem gleichen elektrischen Potential verbunden. Die Elektroden 71, 81, 72, 82 werden jeweils dafür verwendet, um von außen elektrische Spannungsquellen bzw. Spannungsabgriffe an die Innenelektroden anzuschließen.

Die Polarisierung der jeweils zwischen zwei Elektroden liegenden piezoelektrischen Schicht 111, 112 ist durch die Pfeile angegeben. Aus der Figur 1 geht hervor, dass benachbarte piezoelektrische Schichten jeweils in entgegengesetzte Richtung polarisiert sind. Insgesamt erfolgt die Polarisierung senkrecht zu den Eingangselektroden bzw. zu den Ausgangselektroden. Die Polarisationsachsen p der jeweiligen piezoelektrischen Schichten sind in Figur 1 entlang der (horizontal verlaufenden) Längsachse, d. h. Längsachse des Grundkörpers 1 gerichtet. Der Eingangsteil 11 und der Ausgangsteil 12 sind durch die Trennschicht 13 galvanisch voneinander getrennt und durch diese Trennschicht mechanisch miteinander gekoppelt.

An Seitenflächen des Grundkörpers 1 ist zwischen dem Eingangsteil 11 und dem Ausgangsteil 12 eine Abdeckung 102 angebracht. Die Abdeckung 102 kann ein isolierendes Material enthalten, wodurch sich eine Überschlagsgefahr reduzieren lässt.

Die Innenelektroden 31, die der Außenelektrode 71 zugeordnet sind sind untereinander durch die Verbindungsleitung 51 elektrisch leitend verbunden. Die Verbindungsleitung 51 stellt auch die elektrische Kontaktierung mit der Außenelektrode 71 her. Entsprechendes gilt für die Innenelektroden 41, die in der Eingangsseite 11 bzw. in der Primärseite 11 des Transformators dem der Außenelektrode 71 entgegengesetzten elektrischen Pol zugeordnet sind. Die Innenelektroden 41 sind mit der Außenelektrode 81 elektrisch leitend verbunden mittels einer Verbindungsleitung 61.

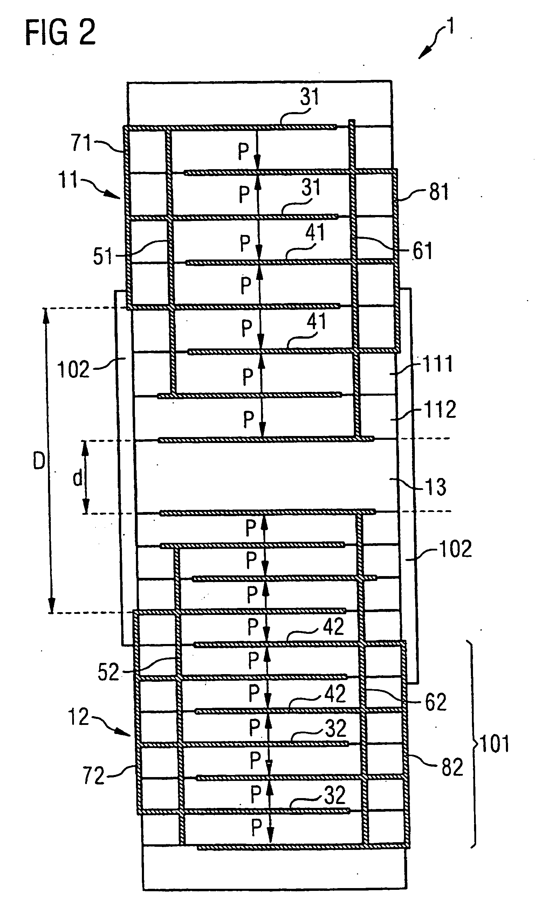

Bei dem Transformator gemäß Figur 2 sind die Außenelektroden 71, 81 bzw. 72, 82 nicht auf Stirnseiten 91, 92 des Grundkörpers 1 angeordnet. Die Außenelektroden 71, 81 bzw. 72, 82 sind auf Seitenflächen des Grundkörpers 1 angeordnet. Die Außenelektrode 71 ist mit Innenelektroden 31 elektrisch leitend verbunden. Mit den weit von der Trennschicht 13 entfernten Innenelektroden 31 ist die Außenelektrode 71 direkt elektrisch leitend verbunden, in dem die Außenelektrode 71 den entsprechenden Teil der Seitenfläche des Grundkörpers bedeckt und somit eine direkte Kontaktierung ermöglicht. Mit der nahe bei der Trennschicht 13 liegenden Innenelektrode 31 ist die Außenelektrode 71 mittels der Verbindungsleitung 51 elektrisch leitend verbunden. Die Verbindungsleitung 51 erstreckt sich darüber hinaus auch in den Bereich der Innenelektroden, die weit von der Trennschicht 13 entfernt sind. Entsprechendes gilt für die Innenelektroden 41, die mit der Außenelektrode 81 verbunden sind.

Entsprechendes gilt für die Innenelektroden 32, 42 im Ausgangsteil des Transformators nach Figur 2. Auch dort sind die Außenelektroden 72 bzw. 82 im weiter von der Trennschicht 13 entfernten Teil auf Seitenflächen des Grundkörpers 1 angeordnet. Durch die spezielle Positionierung der Außenelektroden kann erreicht werden, dass der Abstand von zwei Außenelektroden, beispielsweise der Abstand D der Außenelektroden 71 und 72 größer ist als die Dicke d der Trennschicht 13. Dadurch kann die Isolationsfestigkeit verbessert werden.

Im Mittelbereich des Grundkörpers 1 kann noch zusätzlich eine Abdeckung 102 auf der Oberfläche des Grundkörpers aufgebracht werden. Die Abdeckung 102 kann zusätzlich isolieren und damit die Überschlagsgefahr weiter reduzieren. Vorteilhafterweise bedeckt die Abdeckung 102 zumindest die Kanten der Außenelektroden (71, 81, 72, 82).

Es wird noch darauf hingewiesen, dass die Außenelektrode 82 im Bereich eines Schwingungsknotens 101 des Grundkörpers 1 liegt.

Die Lage der Schwingungsknoten bzw. -bäuche hängt von der Geometrie und den Abmessungen des Transformators ab. Beispielsweise befinden sich die Schwingungsknoten bei einem wie in Figur 2 dargestellten Transformator bei 0,25 x L und 0,75 x L, wobei L die Länge des Transformators zwischen den beiden Stirnseiten bezeichnet.

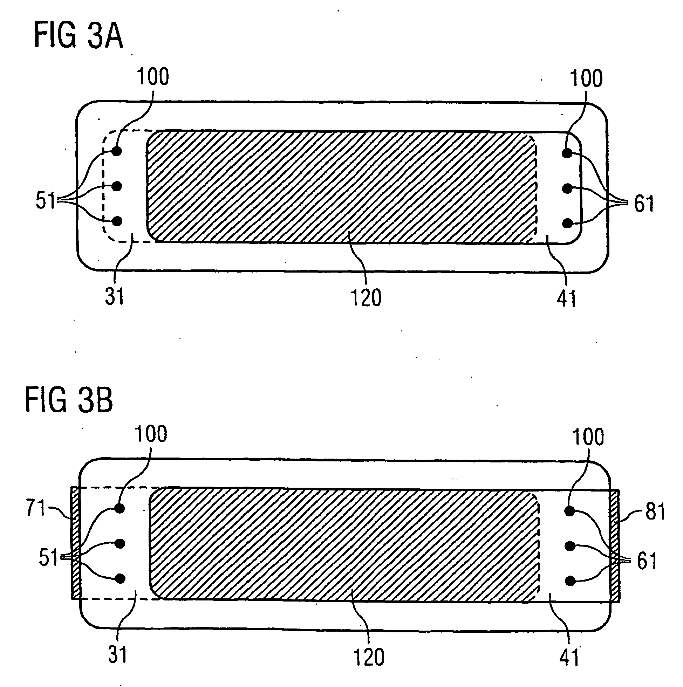

Figur 3A zeigt einen Querschnitt durch das Bauelement aus Figur 1 in einer Ebene, in der eine Innenelektrode 41 annähernd rechteckförmig verläuft. Die direkt benachbarte, ebenfalls rechteckförmig verlaufende Innenelektrode 31 ist durch gestrichelte Linien gekennzeichnet. Der Überlappungsbereich zwischen der Innenelektrode 41 und der Innenelektrode 31 ist mit dem Bezugszeichen 120 markiert und durch Schraffur gekennzeichnet. Es ist in Figur 3A gezeigt, wie mit einer elektrisch leitenden Füllung 100 gefüllte Löcher in dem Keramikmaterial dazu verwendet werden, um Verbindungsleitungen 51 bzw. 61 zu bilden. Auf jeder Seite des Transformators sind dabei nach Figur 3A drei Verbindungsleitungen 51, 61 ausgebildet. Die Zahl der Verbindungsleitungen ist aber beliebig wählbar, es kann auch nur eine Verbindungsleitung auf jeder Seite oder auf der Primärseite insgesamt nur eine innenliegende Verbindungsleitung ausgebildet sein.

Figur 3B zeigt einen Querschnitt durch das Bauelement aus Figur 2 in einer Ebene, in der eine Innenelektrode 41 annähernd rechteckförmig verläuft. Die direkt benachbarte, ebenfalls rechteckförmig verlaufende Innenelektrode 31 ist durch gestrichelte Linien gekennzeichnet. Der Überlappungsbereich zwischen der Innenelektrode 41 und der Innenelektrode 31 ist mit dem Bezugszeichen 120 markiert und durch Schraffur gekennzeichnet. Es ist in Figur 3B gezeigt, wie mit einer elektrisch leitenden Füllung 100 gefüllte Löcher in dem Keramikmaterial dazu verwendet werden, um Verbindungsleitungen 51 bzw. 61 zu bilden. Auf jeder Seite des Transformators sind dabei nach Figur 3B drei Verbindungsleitungen 51, 61 ausgebildet. Ferner sind die auf den Seitenflächen des Grundkörpers 1 angeordneteen Außenelektroden 71, 81 dargestellt. Die Außenelektrode 71 bzw. 81 ist dabei mit der Innenelektrode 31 bzw. 41 elektrisch leitend verbunden.

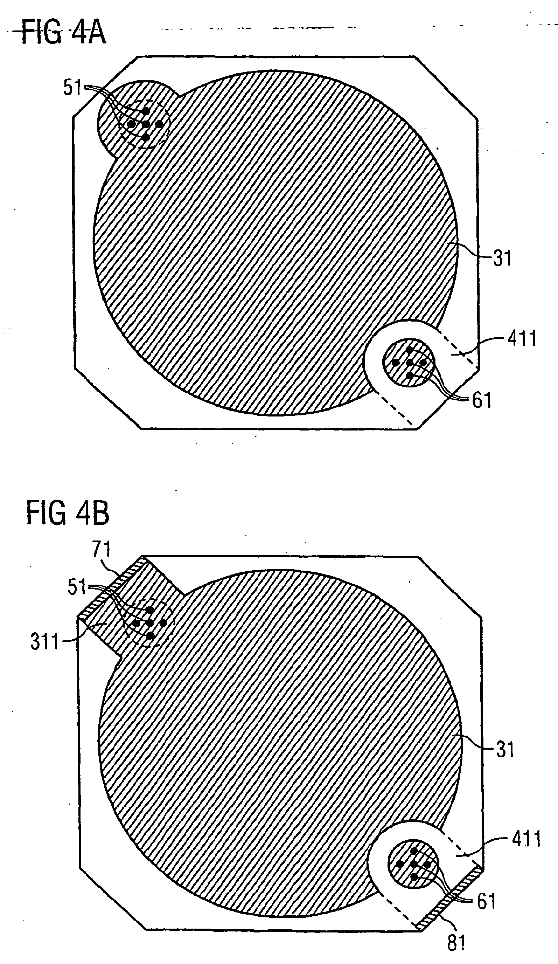

Figur 4A zeigt einen Querschnitt durch ein Bauelement gemäß Figur 1 in einer Ebene, in der die annähernd kreisförmige Innenelektrode 31 liegt. Im Bereich der Innenelektrode 31 ist durch einen gestrichelten Kreis der Bereich markiert, der mit Verbindungsleitungen 51 versehen ist. Diese Verbindungsleitungen 51 sind entsprechend wie in den Figuren 3 und b durch mit einer leitfähigen Füllung 100 versehenen Löcher gebildet. Sie verbinden übereinanderliegende Innenelektroden 31 miteinander. In der unteren Hälfte von Figur 4A ist ein Isolierabschnitt 411 dargestellt. Der Isolierabschnitt 411 ist gebildet in Form eines Kreisrings der auf einer Seite einen abgeflachten Abschnitt aufweist. Insbesondere ist im Bereich des Isolierabschnitts 411 die Innenelektrode 31 metallisierungsfrei. Im Innern des Isolierabschnitts 411 sind in dem gestrichelt markierten Kreisbereich Verbindungsleitungen 61 gebildet, die die über der Innenelektrode 31 liegende Innenelektrode 41 mit der unter der Innenelektrode 31 liegenden Innenelektrode 41 verbinden.

Figur 4B zeigt einen Querschnitt durch ein Bauelement gemäß Figur 2 in einer Ebene, in der die annähernd kreisförmige Innenelektrode 31 liegt. Es ist gezeigt die Außenelektrode 71, die über einen Zuleitungsabschnitt 311 mit der Innenelektrode 31 verbunden ist. Zuleitungsabschnitt 311 und Innenelektrode 31, die in der Zeichenebene liegen, sind durch Schraffur gekennzeichnet. Im Bereich der Innenelektrode 31 bzw. der Zuleitung 311 ist durch einen gestrichelten Kreis der Bereich markiert, der mit Verbindungsleitungen 51 versehen ist. Diese Verbindungsleitungen 51 sind entsprechend wie in den Figuren 3A und B durch mit einer leitfähigen Füllung 100 versehenen Löchern gebildet. Sie verbinden übereinanderliegende Innenelektroden 31 miteinander.

In der unteren Hälfte von Figur 4B ist die gegenüberliegende Außenelektrode 81 gezeigt. Sie ist durch einen Isolierabschnitt 411 elektrisch von der Innenelektrode 31 isoliert. Der Isolierabschnitt 411 ist gebildet in Form eines Kreisrings der auf einer Seite einen abgeflachten Abschnitt aufweist. Insbesondere ist im Bereich des Isolierabschnitts 411 die Innenelektrode 31 metallisierungsfrei. Im Innern des Isolierabschnitts 411 sind in dem gestrichelt markierten Kreisbereich Verbindungsleitungen 61 gebildet, die die über der Innenelektrode 31 liegende Innenelektrode 41 mit der unter der Innenelektrode 31 liegenden Innenelektrode 41 verbinden.

In der über der Zeichenebene und der unter der Zeichenebene liegenden Ebene der Innenelektroden 41 sind entsprechend der Formgebung des Isolierabschnitts 411 geformte Verbindungsabschnitts vorgesehen, die die Verbindung zur Außenelektrode 81 herstellen. Die Verbindungsabschnitte, die den Innenelektroden 41 zugeordnet sind haben die selbe Form wie der Verbindungsabschnitt 311 im oberen Teil von Figur 4B.

Vorzugsweise sind auch die Innenelektroden des Transformators vollständig innerhalb des Grundkörpers angeordnet und verlaufen nicht bis zur Oberfläche des Grundkörpers. Die hier beschriebenen Transformatoren sind nicht beschränkt auf Transformatoren deren piezoelektrische Keramik PZT enthält. Vielmehr können auch andere geeignete Keramikmaterialien verwendet werden.

### Bezugszeichenliste

- 1: Grundkörper
- 11: Eingangsteil
- 12: Ausgangsteil
- 13: Trennschicht
- 31, 41: Eingangselektroden
- 32, 42: Ausgangselektroden
- 51, 61, 52, 62: Verbindungsleitungen
- 71, 81, 72, 82: Außenelektroden
- 91, 92: Stirnseiten
- 100: elektrisch leitende Füllung
- 101: Bereich eines Schwingungsknotens
- 102: Abdeckung
- 111, 112: keramische Schicht
- 120: Überlappbereich
- 311: Zuleitungsabschnitt
- 411: Isolierabschnitt
- D: Abstand
- d: Dicke der Trennschicht
- P: Polarisierung

## Patentansprüche

1. Piezoelektrische Vielschichttransformator mit einem keramischen Grundkörper (1), in dem mehrere piezoelektrische Schichten (111, 112) entlang einer Längsachse des Grundkörpers übereinander angeordnet und entlang der Längsachse des Grundkörpers (1) polarisiert sind und der einen Eingangsteil (11) und einen Ausgangsteil (12) entlang der Längsachse des Grundkörpers (1) aufweist, und mit wenigstens einer Verbindungsleitung (51,61,52,62), die eine Mehrzahl von Innenelektroden (31,41,32,42) kontaktiert,
bei dem die wenigstens eine Verbindungsleitung (51,61,52,62) im Inneren des Grundkörpers (1) angeordnet ist und bei dem eine Außenelektrode (71,81,72,82) auf einer Stirnseite (91,92) des Grundkörpers (1) angeordnet ist.

2. Transformator nach Anspruch 1,
der ein Eingangsteil (11) und ein Ausgangsteil (12) sowie eine dazwischen liegende Trennschicht (13) aufweist, wobei der Abstand zwischen der Außenelektrode . (71,81,72,82) des Eingangsteils (11) und der Außenelektrode des Ausgangsteils (12) größer ist als die Dicke der Trennschicht.

3. Transformator nach wenigstens einem der vorhergehenden Ansprüche,
bei dem die Verbindungsleitung (51,61,52,62) in Keramikmaterial eingebettet ist.

4. Transformator nach wenigstens einem der vorhergehenden Ansprüche,
bei dem die Verbindungsleitung (51,61,52,62) gebildet ist durch ein Loch im Grundkörper (1), das eine elektrisch leitende Füllung (100) enthält.

5. Transformator nach wenigstens einem der vorhergehenden Ansprüche,
bei dem die Außenelektrode (71, 81, 72, 82) im Bereich eines Schwingungsknotens (101) des Grundkörpers (1) angeordnet ist.

6. Transformator nach wenigstens einem der vorhergehenden Ansprüche,
bei dem wenigstens ein Teil der Oberfläche des Grundkörpers (1) mit einer isolierenden Schicht (102) bedeckt ist.

7. Transformator nach einem der Ansprüche 1 bis 5,
bei dem wenigstens ein Teil der Oberfläche des Grundkörpers (1) mit einer isolierenden Schicht (102) enthaltend ein anorganisches Material bedeckt ist.

8. Transformator nach einem der Ansprüche 1 bis 5,
bei dem wenigstens ein Teil der Oberfläche des Grundkörpers (1) mit einer isolierenden Schicht (102) enthaltend ein organisches Material bedeckt ist.

## Claims

1. Piezoelectric multilayer transformer comprising a ceramic basic body (1), in which a plurality of piezoelectric layers (111, 112) are arranged one above another along a longitudinal axis of the basic body and are polarized along the longitudinal axis of the basic body (1) and which has an input part (11) and an output part (12) along the longitudinal axis of the basic body (1), and comprising at least one connecting line (51, 61, 52, 62) which makes contact with a plurality of internal electrodes (31, 41, 32, 42), wherein the at least one connecting line (51, 61, 52, 62) is arranged in the interior of the basic body (1), and wherein an external electrode (71, 81, 72, 82) is arranged on a front face (91, 92) of the basic body (1).

2. Transformer according to Claim 1,
which comprises an input part (11) and an output part (12) and a separating layer (13) situated therebetween, wherein the distance between the external electrode (71, 81, 72, 82) of the input part (11) and the external electrode of the output part (12) is greater than the thickness of the separating layer.

3. Transformer according to at least one of the preceding claims,
wherein the connecting line (51, 61, 52, 62) is embedded in ceramic material.

4. Transformer according to at least one of the preceding claims,
wherein the connecting line (51, 61, 52, 62) is formed by a hole in the basic body (1), which hole contains an electrically conductive filling (100).

5. Transformer according to at least one of the preceding claims,
wherein the external electrode (71, 81, 72, 82) is arranged in the region of an oscillation node (101) of the basic body (1).

6. Transformer according to at least one of the preceding claims,
wherein at least one part of the surface of the basic body (1) is covered with an insulating layer (102).

7. Transformer according to any of Claims 1 to 5,
wherein at least one part of the surface of the basic body (1) is covered with an insulating layer (102) containing an inorganic material.

8. Transformer according to any of Claims 1 to 5,
wherein at least one part of the surface of the basic body (1) is covered with an insulating layer (102) containing an organic material.

## Revendications

1. Transformateur multicouche piézoélectrique comprenant un corps de base en céramique (1) dans lequel plusieurs couches piézoélectriques (111, 112) sont disposées les unes au-dessus des autres le long d'un axe longitudinal du corps de base et sont polarisées le long de l'axe longitudinal du corps de base (1) et lequel présente une partie d'entrée (11) et une partie de sortie (12) le long de l'axe longitudinal du corps de base (1), et comprenant au moins une ligne de liaison (51, 61, 52, 62) qui met en contact une pluralité d'électrodes internes (31, 41, 32, 42),
dans lequel l'au moins une ligne de liaison (51, 61, 52, 62) est disposée à l'intérieur du corps de base (1) et dans lequel une électrode externe (71, 81, 72, 82) est disposée sur un côté frontal (91, 92) du corps de base (1).

2. Transformateur selon la revendication 1, lequel présente une partie d'entrée (11) et une partie de sortie (12) ainsi qu'une couche de séparation (13) qui se trouve entre celles-ci, l'écart entre l'électrode externe (71, 81, 72, 82) de la partie d'entrée (11) et l'électrode externe de la partie de sortie (12) étant supérieur à l'épaisseur de la couche de séparation.

3. Transformateur selon au moins l'une des revendications précédentes, dans lequel la ligne de liaison (51, 61, 52, 62) est enrobée dans le matériau en céramique.

4. Transformateur selon au moins l'une des revendications précédentes, dans lequel la ligne de liaison (51, 61, 52, 62) est formée à travers un trou dans le corps de base (1) qui contient un remplissage (100) électriquement conducteur.

5. Transformateur selon au moins l'une des revendications précédentes, dans lequel l'électrode externe (71, 81, 72, 82) est disposée dans la zone d'un noeud d'oscillation (101) du corps de base (1).

6. Transformateur selon au moins l'une des revendications précédentes, dans lequel au moins une partie de la surface du corps de base (1) est recouverte d'une couche isolante (102).

7. Transformateur selon l'une des revendications 1 à 5, dans lequel au moins une partie de la surface du corps de base (1) est recouverte d'une couche isolante (102) contenant un matériau inorganique.

8. Transformateur selon l'une des revendications 1 à 5, dans lequel au moins une partie de la surface du corps de base (1) est recouverte d'une couche isolante (102) contenant un matériau organique.
